# EUROPÄISCHE PATENTSCHRIFT

(11) **EP 3 313 603 B1**
(45) Veröffentlichungstag und Bekanntmachung des Hinweises auf die Patenterteilung: **16.10.2019**
(21) Anmeldenummer: 16732273.4
(22) Anmeldetag: 23.06.2016
(51) Int. Cl.: B23K 26/00, B28D 1/00, B28D 1/22, B28D 5/00, C03B 33/02, C03B 33/09, C03B 33/095, H01L 21/268, H01L 21/304, B23K 26/359, B23K 26/70, B23K 26/53, B23K 26/0622, B23K 26/60, B23K 101/40

(54) **VERFAHREN ZUM FÜHREN EINES RISSES IM RANDBEREICH EINES SPENDERSUBSTRATS**
METHOD FOR GUIDING A CRACK IN THE PERIPHERAL REGION OF A DONOR SUBSTRATE
PROCÉDÉ POUR GUIDER LE CHEMINEMENT D'UNE FISSURE DANS LA ZONE MARGINALE D'UN SUBSTRAT DONNEUR

(30) Priorität: 23.06.2015 DE 102015008037
(43) Veröffentlichungstag der Anmeldung: 02.05.2018
(73) Patentinhaber: Siltectra GmbH, 01099 Dresden (DE)
(72) Erfinder: SWOBODA, Marko, 01097 Dresden (DE); BEYER, Christian, 09599 Freiberg (DE); SCHILLING, Franz, 01454 Radeberg (DE); RICHTER, Jan, 01109 Dresden (DE)
(74) Vertreter: Müller Hoffmann & Partner
(86) Internationale Anmeldenummer: PCT/EP2016/064535
(87) Internationale Veröffentlichungsnummer: WO 2016/207276

(56) Entgegenhaltungen:
- DE-A1-102014 014 486
- JP-A- H0 919 857
- JP-A- 2006 142 556
- JP-A- 2006 245 498
- JP-A- 2013 049 161
- US-A1- 2015 159 279

## Beschreibung

Die vorliegende Erfindung bezieht sich gemäß dem Oberbegriff des Anspruchs 1 auf ein Verfahren zum Abtrennen von Festkörperscheiben von einem Spendersubstrat (siehe, z.B., JP 2006 142 556 A).

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Besonders kritisch ist hierbei die Rissführung, da nur bei einer sehr präzisen Rissführung Festkörperscheiben mit einem geringen TTV unmittelbar erzeugbar sind.

Es wurde erkannt, dass mittels LASER-Strahlen zwar Modifikationen zum Vorgeben eines Rissverlaufs beabstandet zum Rand des Festkörpers in einem Festkörper erzeugbar sind, dies jedoch im Bereich des Rands eines Festkörpers aufgrund von Randeffekten nicht ohne weiteres möglich ist. Trifft der Laserfokus mit seiner Mitte direkt die Kante des Materials, so ist trifft eine Hälfte des Strahls mit finiter Ausdehnung den Festkörper, die andere Hälfte läuft in der Luft. Aufgrund des Unterschieds im Brechindex führt dies zu einer Schädigung an der Seite des Festkörpers, weit oberhalb der eigentlich intendierten Schadschicht nach Brechindexkorrektur. Da außerdem nur die Hälfte oder ein Bruchteil der Laserstrahlung ins Material gekoppelt wird, ist die Schädigung am Rand gegenüber der Mitte des Festkörpers reduziert. Diese verminderte Schädigung führt dazu, dass der Riss beim Verlauf am Rand Verwerfungen zeigt oder nicht in der Laserebene verläuft.

Es ist somit die Aufgabe der vorliegenden Erfindung ein Verfahren bereit zu stellen, das die Herstellung von Wafern mit einem geringen TTV ermöglicht.

Die zuvor genannte Aufgabe wird durch ein Verfahren gemäß Anspruch 1 gelöst. Das erfindungsgemäße Verfahren zum Abtrennen von mindestens einer Festkörperlage, insbesondere einer Festkörperscheibe, von einem Spendersubstrat umfasst bevorzugt mindestens die Schritte: Bereitstellen eines Spendersubstrats, Erzeugen von Modifikationen im Inneren des Spendersubstrats mittels LASER-Strahlen, wobei durch die Modifikationen ein Ablösebereich vorgegeben wird, entlang dem eine Abtrennung der Festkörperlage von dem Spendersubstrat erfolgt, Abtragen von Material des Spendersubstrats ausgehend von einer sich in Umfangsrichtung des Spendersubstrats erstreckenden Oberfläche in Richtung Zentrum des Spendersubstrats, insbesondere zum Erzeugen einer umlaufenden Vertiefung, wobei durch den Materialabtrag der Ablösebereich freigelegt wird, Abtrennen der Festkörperlage von dem Spendersubstrat, wobei das Spendersubstrat im Ablösebereich durch die Modifikationen derart geschwächt wird, dass sich die Festkörperlage infolge des Materialabtrags von dem Spendersubstrat ablöst oder nach dem Materialabtrag eine solche Anzahl an Modifikationen erzeugt wird, dass das Spendersubstrat im Ablösebereich derart geschwächt wird, dass sich die Festkörperlage von dem Spendersubstrat ablöst oder eine Spannungserzeugungsschicht an einer zur umlaufenden Oberfläche geneigt ausgerichteten, insbesondere ebenen, Oberfläche des Spendersubstrats erzeugt oder angeordnet wird und durch ein thermisches Beaufschlagen der Spannungserzeugungsschicht mechanische Spannungen in dem Spendersubstrat erzeugt werden, wobei durch die mechanischen Spannungen ein Riss zum Abtrennen einer Festkörperlage entsteht, der sich ausgehend von der durch den Materialabtrag freigelegten Oberfläche des Spendersubstrats entlang der Modifikationen ausbreitet.

Diese Lösung ist vorteilhaft, da sich ein Rand des Spendersubstrats, in dessen Bereich sich nur sehr aufwendig Modifikationen zur weiteren Ausbildung des Ablösebereichs erzeugen lassen, entfernen oder reduzieren oder modifizieren lässt. Hierdurch erfolgt somit ein radialer Materialabtrag, durch den der Abstand der umlaufenden Oberfläche zum Ablösebereich reduziert wird.

Weitere bevorzugte Ausführungsformen sind Gegenstand der Unteransprüche und/oder der nachfolgenden Beschreibungsteile.

Der durch die Modifikationen vorgegebene Ablösebereich ist gemäß einer weiteren bevorzugten Ausführungsform der vorliegenden Erfindung vor dem Materialabtrag weiter zur umlaufenden Oberfläche des Spendersubstrats beabstandet als nach dem Materialabtrag. Diese Ausführungsform ist vorteilhaft, da der Ablösebereich somit einfach zu erzeugen ist und dennoch nach dem Materialabtrag bevorzugt an der äußeren umlaufenden Oberfläche des Spendersubstrats angrenzt.

Die Modifikationen zum Vorgeben des Ablösebereichs werden gemäß einer weiteren bevorzugten Ausführungsform der vorliegenden Erfindung vor dem Materialabtrag erzeugt und durch den Materialabtrag wird zumindest stellenweise eine Reduzierung des Abstands des Ablösebereichs auf weniger als 10mm, insbesondere auf weniger als 5mm und bevorzugt auf weniger als 1mm, erreicht oder die Modifikationen zum Vorgeben des Ablösebereichs werden nach dem Materialabtrag erzeugt, wobei die Modifikationen derart erzeugt werden, dass der Ablösebereich zumindest stellenweise weniger als 10mm, insbesondere weniger als 5mm und bevorzugt weniger als 1mm, zu einer durch den Materialabtrag freigelegten Oberfläche beabstandet ist. Besonders bevorzugt sind zumindest einzelne Modifikationen des Ablösebereichs Bestandteil der durch den Materialabtrag freigelegten und zumindest teilweise und bevorzugt vollständig umlaufenden Oberfläche des Spendersubstrats.

Gemäß einer weiteren bevorzugten Ausführungsform der vorliegenden Erfindung wird das Material mittels Ablations-LASER-Strahlen entfernt.

Die Modifikationen werden hierbei bevorzugt mit möglichst kurzen Pulsen in möglichst kleinem vertikalen Bereich durch Fokussierung im Material mit hoher numerischer Apertur erreicht.

Bei der Ablation werden die Ablations-LASER-Strahlen an der Oberfläche des Materials fokussiert, mit einer geringeren numerischen Apertur und oft einer Wellenlänge, die vom Material linear absorbiert wird. Die lineare Absorption der Ablations-LASER-Strahlen an der Materialoberfläche führt zu einer Verdampfung des Materials, der Ablation, also einem Materialabtrag, nicht nur einer Strukturveränderung

Diese Lösung ist vorteilhaft, da ein Randbereich des Spendersubstarts mittels einer materialabtragenden Behandlung bearbeitet wird, durch die der äußere Rand des Spendersubstrats im Bereich der Ebene, in der sich der Riss ausbreitet, in Richtung Zentrum des Spendersubstrats verlagert wird. Die Verlagerung erfolgt bevorzugt soweit in Richtung Zentrum, dass in Abhängigkeit der Eindringtiefe der LASER-Strahlen und/oder der Winkel der LASER-Strahlen zueinander alle LASER-Strahlen über dieselbe ebene Oberfläche in das Spendersubstrat eindringen können.

Die Vertiefung umgibt das Spendersubstrats gemäß einer weiteren bevorzugten Ausführungsform der vorliegenden Erfindung vollständig in Umfangsrichtung. Diese Ausführungsform ist vorteilhaft, da der Riss über den gesamten Umfang des Spendersubstrats definiert in das Spendersubstrat einleitbar ist.

Die Vertiefung verläuft gemäß einer weiteren bevorzugten Ausführungsform der vorliegenden Erfindung in Richtung Zentrum bis zu einem Vertiefungsende hin enger werdend, insbesondere keil- oder kerbförmig, wobei das Vertiefungsende in der Ebene liegt, in der sich der Riss ausbreitet. Diese Ausführungsform ist vorteilhaft, da durch das Vertiefungsende eine Kerbe schaffen wird, durch welche die Ausbreitrichtung des Risses vorgegeben wird.

Die asymmetrische Vertiefung wird gemäß einer weiteren bevorzugten Ausführungsform der vorliegenden Erfindung mittels eines zur Vertiefung zumindest abschnittsweise negativ geformten Schleifwerkzeugs erzeugt. Diese Ausführungsform ist vorteilhaft, das Schleifwerkzeug gemäß der zu erzeugenden Kante bzw. Vertiefung herstellbar ist.

Das Schleifwerkzeug weist gemäß einer weiteren bevorzugten Ausführungsform der vorliegenden Erfindung mindestens zwei verschieden geformte Bearbeitungsanteile auf, wobei ein erster Bearbeitungsanteil zum Bearbeiten des Spendersubstrats im Bereich der Unterseite einer abzutrennenden Festkörperscheibe und ein zweiter Bearbeitungsanteil zum Bearbeiten des Spendersubstrats im Bereich der Oberseite der von dem Spendersubstrat abzutrennenden Festkörperscheibe bestimmt ist. Diese Ausführungsform ist vorteilhaft, da mittels des Schleifwerkzeugs neben Umformungen zum Bewirken einer verbesserten Rissführung ebenfalls Umformungen zur besseren Handhabung zeitgleich oder zeitversetzt an dem Spendersubstart bzw. an den eine oder mehrere Festkörperscheibe/n ausbildenden Anteilen des Spendersubstrats bewirkt werden können.

Gemäß einer weiteren bevorzugten Ausführungsform der vorliegenden Erfindung erzeugt der erste Bearbeitungsanteil eine tiefere oder volumenmäßig größere Vertiefung in dem Spendersubstrat als der zweite Bearbeitungsanteil, wobei der erste Bearbeitungsanteil und/oder der zweite Bearbeitungsanteil gebogene oder gerade Schleifflächen aufweisen. Bevorzugt weist der erste Bearbeitungsanteil eine gebogene Hauptschleiffläche auf und der zweite Bearbeitungsanteil weist bevorzugt ebenfalls eine gebogene Nebenschleiffläche auf, wobei der Radius der Hauptschleiffläche größer ist als der Radius der Nebenschleiffläche, bevorzugt ist der Radius der Hauptschleiffläche mindestens doppelt so groß wie der Radius der Nebenschleiffläche oder der erste Bearbeitungsanteil weist eine gerade Hauptschleiffläche auf und der zweite Bearbeitungsanteil weist eine gerade Nebenschleiffläche auf, wobei mittels der Hauptschleiffläche mehr Material als mit der Nebenschleiffläche von dem Spendersubstrat entfernt wird oder der erste Bearbeitungsanteil weist eine gerade Hauptschleiffläche auf und der zweite Bearbeitungsanteil weist eine gebogene Nebenschleiffläche auf oder der erste Bearbeitungsanteil weist eine gebogene Hauptschleiffläche auf und der zweite Bearbeitungsanteil weist eine gerade Nebenschleiffläche auf.

Bevorzugt weist das Schleifwerkezeug eine Vielzahl, insbesondere mehr als 2, 3, 4, 5, 6, 7, 8, 9 oder 10, an Bearbeitungsanteilen auf, um eine entsprechende Vielzahl an unterschiedlichen Festkörperscheiben zuordenbaren Anteile des Spendersubstrats spanend bzw. materialentfernend zu bearbeiten.

Gemäß einer weiteren bevorzugten Ausführungsform der vorliegenden Erfindung werden die Ablations-LASER-Strahlen mit einer Wellenlänge im Bereich zwischen 300 nm (UV-Ablation mit frequenzverdreifachtem Nd:YAG- oder anderem Festkörperlaser) und 10 µm (CO₂-Gaslaser, oft für Gravur und Schneidprozesse verwendet), mit einer Pulsdauer von weniger als 100 Mikrosekunden und bevorzugt von weniger als 1 Mikrosekunde und besonders bevorzugt von weniger als 1/10 Mikrosekunde und mit einer Pulsenergie von mehr als 1µJ und bevorzugt von mehr als 10 µJ erzeugt. Diese Ausführungsform ist vorteilhaft, da mittels einer LASER-Einrichtung und nicht mittels eines sich abnutzenden Schleifwerkezeugs die Vertiefung erzeugbar ist.

Die Modifikationen im Spendersubstrat werden materialabhängig bevorzugt mit den nachfolgend angeführten Konfigurationen bzw. LASER-Parametern erzeugt: Besteht das Spendersubstrat aus Silizium oder weist das Spendersubstart Silizium auf, so werden bevorzugt Nanosekundenpulse oder kürzer(<500ns), eine Pulsenergie im Mikrojoulebereich (<100µJ) und eine Wellenlänge >1000nm verwendet.

Bei allen anderen Materialien und Materialkombinationen werden bevorzugt Pulse <5 Pikosekunden, Pulsenergien im Mikrojoulebereich (<100µJ) und Wellenlängen Wellenlängen variabel zwischen 300nm und 2500nm verwendet.

Wichtig ist hierbei, dass eine große Apertur vorgesehen wird, um tief ins Material zu gelangen. Die Apertur zur Erzeugung der Modifikationen im Inneren des Spendersubstrats ist somit bevorzugt größer als die Apertur zur Ablation von Material mittels der Ablations-LASER-Strahlen zum Erzeugen der Vertiefung. Bevorzugt ist die Apertur mindestens um ein Vielfaches, insbesondere mindestens um das 2, 3, 4, 5, 6-fache größer als die Apertur zur Ablation von Material mittels der Ablations-LASER-Strahlen zum Erzeugen der Vertiefung. Die Fokusgröße zur Erzeugung einer Modifikation ist, insbesondere hinsichtlich ihres Durchmessers, bevorzugt kleiner als 10µm, bevorzugt kleiner als 5µm und besonders bevorzugt kleiner als 3µm.

Alternativ kann sich die vorliegende Erfindung auf ein Verfahren zum Abtrennen von Festkörperscheiben von einem Spendersubstrat beziehen. Das erfindungsgemäße Verfahren umfasst dabei bevorzugt mindestens die Schritte: Bereitstellen eines Spendersubstrats, Erzeugen von Modifikationen im Inneren des Spendersubstrats mittels LASER-Strahlen, wobei die LASER-Strahlen über eine ebene Oberfläche des Spendersubstrats in das Spendersubstrat eindringen, wobei die Gesamtheit der LASER-Strahlen derart gegenüber der Oberfläche des Spendersubstrats geneigt ist, dass ein erster Anteil der LASER-Strahlen in einem ersten Winkel zur Oberfläche des Spendersubstrats in das Spendersubstrat eindringt und mindestens ein weiterer Anteil in einem zweiten Winkel zur Oberfläche des Spendersubstrats in das Spendersubstrat eindringt, wobei sich der Betrag des ersten Winkels von dem Betrag des zweiten Winkels unterscheidet, wobei der erste Anteil der LASER-Strahlen und der zweite Anteil der LASER-Strahlen zum Erzeugen der Modifikation im Spendersubstrat fokussiert werden, wobei sich die Festkörperscheibe durch die erzeugten Modifikationen von dem Spendersubstrat ablöst oder eine Spannungserzeugungsschicht an der ebenen Oberfläche des Spendersubstrats erzeugt oder angeordnet wird und durch ein thermisches Beaufschlagen der Spannungserzeugungsschicht mechanische Spannungen in dem Spendersubstrat erzeugt werden, wobei durch die mechanischen Spannungen ein Riss zum Abtrennen einer Festkörperschicht entsteht, der sich entlang der Modifikationen ausbreitet. Bevorzugt wird der Spenderwafer und/oder die die LASER-Strahlen emittierende LASER-Einrichtung während der Erzeugung der Modifikationen um eine Rotationsachse rotiert. Besonders bevorzugt erfolgt zusätzlich oder alternativ zur Rotation des Spenderwafers eine Veränderung des Abstandes der LASER-Strahlen zum Zentrum des Spenderwafers.

Die Gesamtheit der LASER-Strahlen ist gemäß einer weiteren bevorzugten Ausführungsform der vorliegenden Erfindung für die Erzeugung von Modifikationen im Bereich des Zentrums des Spendersubstrats und für die Erzeugung von Modifikationen im Bereich eines sich in radialer Richtung ergebenden Rands des Spendersubstrats in derselben Ausrichtung gegenüber der ebenen Oberfläche des Spendersubstrats ausgerichtet.

Diese Lösung ist vorteilhaft, da der gesamte Querschnitt des Laserstrahls beim Eintritt in den Festkörper eine ebene Fläche trifft, da dann in der Tiefe eine homogene Schädigung auftritt. Diese homogene Schädigung ist bis an den äußeren, insbesondere sich orthogonal zur ebenen Oberfläche erstreckenden, Rand des Spendersubstrats erzeugbar. Somit können die Modifikationen um Randbereich des Spendersubstrats und im Bereich des Zentrums des Spendersubstrats mittels eines Bearbeitungsschritts erzeugt werden.

Der erste Anteil der LASER-Strahlen dringt gemäß einer weiteren bevorzugten Ausführungsform der vorliegenden Erfindung in einem ersten Winkel zur Oberfläche des Spendersubstrats in das Spendersubstrat ein und der weitere Anteil der LASER-Strahlen dringt in einem zweiten Winkel für die Erzeugung von Modifikationen im Bereich des Zentrums des Spendersubstrats und für die Erzeugung von Modifikationen im Bereich eines sich in radialer Richtung ergebenden Rands des Spendersubstrats ein, wobei sich der Betrag des ersten Winkels von dem Betrag des zweiten Winkels stets unterscheidet. Bevorzugt sind der erste Winkel und der zweite Winkel während der Erzeugung der Modifikationen konstant bzw. unverändert bzw. werden nicht verändert. Diese Ausführungsform ist vorteilhaft, da

Die LASER-Einrichtung umfasst gemäß einer weiteren bevorzugten Ausführungsform der vorliegenden Erfindung einen Femtosekunden-LASER (fs-LASER) oder einen Picosekunden-LASER (ps-LASER) und die Energie der LASER-Strahlen des LASER (fs-LASER oder ps-LASER) wird bevorzugt derart gewählt, dass die Schädigungsausbreitung einer jeden Modifikation in der Nutzschicht und/oder der Opferschicht kleiner als 3 mal die Rayleighlänge, bevorzugt kleiner als die Rayleighlänge und besonders bevorzugt kleiner ein Drittel mal die Rayleighlänge ist und/oder die Wellenlänge der LASER-Strahlen des fs-LASER wird derart gewählt, dass die Absorption der Nutzschicht und/oder der Opferschicht kleiner als 10cm⁻¹ und bevorzugt kleiner als 1cm⁻¹ und besonders bevorzugt kleiner als 0,1cm⁻¹ ist und/oder die einzelnen Modifikationen ergeben sich jeweils in Folge einer von dem fs-LASER bewirkten multi-photonen Anregung.

Gemäß einer weiteren bevorzugten Ausführungsform der vorliegenden Erfindung dringen die LASER-Strahlen zum Erzeugen der Modifikationen über eine Oberfläche in den Spenderwafer ein, die Bestandteil der abzutrennenden Festkörperscheibe ist. Diese Ausführungsform ist vorteilhaft, da eine geringere Aufheizung des Spendersubstrats erfolgt, wodurch dieses nur geringen thermischen Spannungen ausgesetzt wird.

Gemäß einer weiteren bevorzugten Ausführungsform der vorliegenden Erfindung umfasst die Ablations-Strahlung beschleunigte Ionen und/oder Plasma und/oder LASER-Strahlen und/oder wird durch Elektronenstrahlheizen oder Ultraschallwellen gebildet und/oder ist Bestandteil eines lithografischen Verfahrens (Elektronenstrahl, UV, Ionen, Plasma) mit mindestens einem Ätzschritt nach zuvor erfolgter Fotolackbeschichtung und/oder das Ablations-Fluid ist ein Flüssigkeitsstrahl, insbesondere ein Wasserstrahl eines Wasserstrahlschneidprozesses.

Die Spannungserzeugungsschicht weist gemäß einer weiteren bevorzugten Ausführungsform der vorliegenden Erfindung ein Polymer, insbesondere Polydimethylsiloxan (PDMS), auf oder besteht daraus, wobei die thermische Beaufschlagung bevorzugt derart erfolgt, dass das Polymer einen Glasübergang erfährt, wobei die Spannungserzeugungsschicht, insbesondere mittels flüssigem Stickstoff, auf eine Temperatur unterhalb der Raumtemperatur (d.h. auf eine Temperatur von weniger als 20°C) oder unterhalb von 0°C oder unterhalb von -50°C oder unterhalb von -100°C oder unterhalb von -110°C, insbesondere auf eine Temperatur unterhalb der Glasübergangstemperatur der Spannungserzeugungsschicht, temperiert wird.

Diese Ausführungsform ist vorteilhaft, da erkannt wurde, dass durch die thermische Beaufschlagung der Spannungserzeugungsschicht, insbesondere durch Ausnutzung der beim Glasübergang auftretenden Eigenschaftsveränderungen des Materials der Spannungserzeugungsschicht, die zur Rissauslösung und Rissführung erforderlichen Kräfte in einem Spendersubstrat erzeugt werden können.

Das Spendersubstrat weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN bzw. besteht aus einem oder mehreren dieser Materialien. Besonders bevorzugt weist das Spendersubstrat eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann das Spendersubstrat eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Das Spendersubstrat weist somit bevorzugt ein Halbleitermaterial oder ein Keramikmaterial auf bzw. besonders bevorzugt besteht das Spendersubstrat aus mindestens einem Halbleitermaterial oder einem Keramikmaterial. Es ist weiterhin denkbar, dass das Spendersubstrat ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7).

Die Gegenstände der Patentanmeldung DE 2013 205 720.2 mit dem Titel: "Verfahren zur Kantenverrundung von aus einem Halbleiter-Ausgangsmaterial erzeugten Halbleiter-Teilstücken und mittels dieses Verfahrens hergestellte Halbleiterprodukte" werden hiermit vollumfänglich durch Bezugnahme zum Gegenstand der vorliegenden Beschreibung gemacht.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft die erfindungsgemäßen Lösungen dargestellt sind. Bauteile oder Elemente oder Verfahrensschritte der erfindungsgemäßen Lösungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1: ein erstes Beispiel für eine Randbehandlung im Rahmen der Festkörperscheibenherstellung;
- Fig. 2: Beispiele von Konturen von Schleifwerkzeugen, wie sie gemäß dem in Fig. 1 gezeigten Verfahren eingesetzt werden können;
- Fig. 3: ein zweites Beispiel für eine Randbehandlung im Rahmen der Festkörperscheibenherstellung; und
- Fig. 4a-4d: ein drittes Beispiel für eine Randbehandlung im Rahmen der Festkörperscheibenherstellung,
- Fig. 5a-5b: Darstellung eines beim Erzeugen von Modifikationen mittels LASER-Strahlen im Randbereich eines Spendersubstrats auftretenden Problems Und
- Fig. 6: eine schematische Darstellung eines Festkörpers, der Vertiefungen aufweist, die von einer Spannungserzeugungsschicht überdeckt bzw. überlagert bzw. verschlossen werden.

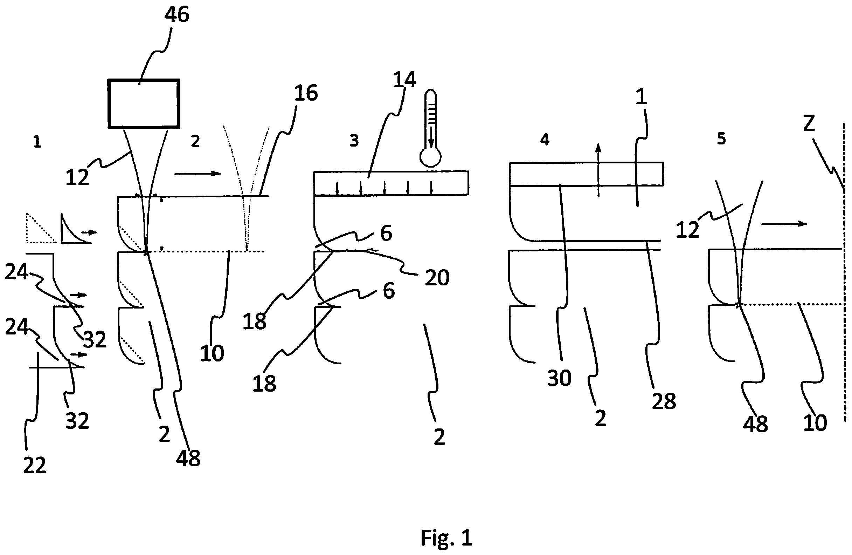

Fig. 1 zeigt 5 Darstellungen, durch die Beispiele für die Festkörperscheibenherstellung bzw. Waferherstellung gezeigt werden. Darstellung 1 zeigt dabei ein Schleifwerkzeug 22, das zwei zueinander beabstandete Bearbeitungsanteile 24 aufweist, die jeweils eine Hauptschleiffläche 32 ausbilden. Die Hauptschleifflächen 32 sind dabei so ausgebildet, dass sie in einem Spendersubstrat 2 Vertiefungen 6 erzeugen. Das Schleifwerkzeug 22 ist bevorzugt als Rotationsschleifwerkzeug oder als Bandschleifwerkzeug ausgebildet.

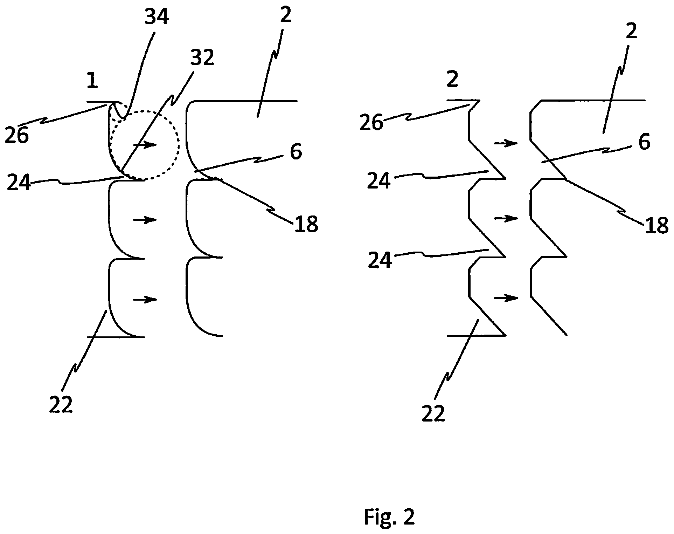

Darstellung 2 der Fig. 1 zeigt ein Spendersubstrat 2, in dem mittels des Schleifwerkzeugs 22 Vertiefungen 6 erzeugt wurden. Die Vertiefungen 6 sind dabei in Längsrichtung des Spenderwafers 2 bevorzugt gleichmäßig zueinander beabstandet, wobei auch denkbar, ist, dass die Abstände unterschiedlich groß sind. Gemäß der zweiten Darstellung in Fig. 2 werden ferner mittels einer LASER-Einrichtung 46 Modifikationen 10 im Spendersubstrat 2 erzeugt. Die LASER-Einrichtung 46 emittiert dazu LASER-Strahlen 12, die über eine bevorzugt ebene Oberfläche 16 des Spendersubstrats 2 in das Spendersubstrat 2 eindringen und an einem Fokuspunkt 48, insbesondere durch eine Mehrphotonenanregung, eine Modifikation 10 der Gitterstruktur des Festkörpers bzw. des Spendersubstrats 2 erzeugt bzw. bewirkt. Die Modifikation 10 stellt hierbei bevorzugt eine Materialumwandlung, insbesondere eine Überführung des Materials in eine andere Phase, oder eine Materialzerstörung dar.

Die dritte Darstellung zeigt, dass eine Spannungserzeugungsschicht 14 an der Oberfläche 16, über welche die LASER-Strahlen 12 zum Erzeugen der Modifikationen 10 in das Spendersubstrat 2 eingeleitet wurden, erzeugt oder angeordnet wurde. Die Spannungserzeugungsschicht 14 wird zum Erzeugen von mechanischen Spannungen im Spendersubstrat 2 thermisch beaufschlagt bzw. temperiert, insbesondere abgekühlt. Durch das thermische Beaufschlagen der Spannungserzeugungsschicht 14, zieht sich die Spannungserzeugungsschicht 14 zusammen, wodurch sich die mechanischen Spannungen in dem Spendersubstrat 2 ergeben. Die zuvor erzeugten Vertiefungen 6 bilden dabei Kerben aus, durch welche die mechanischen Spannungen derart geleitet werden können, dass sich der durch die Spannungen ergebende Riss 20 gezielt in dem durch die Modifikationen 10 vorgegebenen Rissführungsbereich ausbreitet. Die Vertiefungsenden 18 grenzen daher bevorzugt an dem jeweiligen durch die Modifikationen 10 vorgegebenen Rissführungsbereich an. Bevorzugt wird immer nur genau die Festkörperschicht 1 abgespaltet, deren Vertiefung 6 am wenigsten zur Spannungserzeugungsschicht 14 beabstandet ist.

Die Darstellung 4 zeigt einen Zustand, nach erfolgter Rissausbreitung. Die Festkörperscheibe 1 ist von dem Spendersubstrat 2 abgespalten und die Spannungserzeugungsschicht 14 verbleibt zunächst weiterhin an der Oberfläche 16 der Festkörperscheibe 1.

Das Bezugszeichen 28 kennzeichnet, welche Seite der Festkörperscheibe 1 hier als Unterseite der Festkörperscheibe 1 bezeichnet ist und das Bezugszeichen 30 kennzeichnet, welche Seite der Festkörperscheibe 1 hier als Oberseite der Festkörperscheibe 1 bezeichnet ist.

Die Darstellung 5 zeigt ein Verfahren, bei dem ohne eine Spannungserzeugungsschicht 14 eine Ablösung der Festkörperschicht 1 vom Spendersubstrat 2 bewirkt wird. Es werden hierbei bevorzugt nach der Erzeugung der Vertiefung 6 so viele Modifikationen 10 mittels LASER-Strahlen 12 erzeugt, dass sich die Festkörperschicht 1 vom Spendersubstrat 2 ablöst. Die gestrichelte Linie Z kennzeichnet hierbei bevorzugt ein Zentrum bzw. eine Rotationsachse des Spendersubstrats 2. Das Spendersubstrat 2 ist bevorzugt um die Rotationsachse Z rotierbar.

Fig. 2 zeigt zwei Darstellungen, wobei jede Darstellung ein Schleifwerkzeug 22 mit einer bestimmten Kontur zeigt. Wird in Bezug auf das Schleifwerkzeug von einem ebenen, geraden oder gebogenen Anteil gesprochen, dann ist damit immer ein Anteil der gezeigten Kontur zu verstehen. Selbstverständlich kann das Schleifwerkzeug 22 z.B. als ein Rotationsschleifwerkezeug ausgebildet sein, wodurch sich die an die Kontur in Umfangsrichtung anschließenden Anteile in Umfangsrichtung bevorzugt gebogen erstrecken würden. Das in der ersten Darstellung der Fig. 2 gezeigte Schleifwerkzeug 22 weist einen ersten Bearbeitungsanteil 24 auf, der eine gebogene Hauptschleiffläche 32 aufweist, und weist einen zweiten Bearbeitungsanteil 26 auf, der eine gebogene Nebenschleiffläche 34 aufweist, wobei der Radius der Hauptschleiffläche 32 größer ist als der Radius der Nebenschleiffläche 34, bevorzugt ist der Radius der Hauptschleiffläche 32 mindestens doppelt, dreifach, vierfach oder fünffach so groß, wie der Radius der Nebenschleiffläche 34.

Gemäß der zweiten Darstellung der Fig. 2 weist der erste Bearbeitungsanteil 24 des Schleifwerkzeugs 22 eine gerade Hauptschleiffläche 32 auf und der zweite Bearbeitungsanteil 26 weist eine gerade Nebenschleiffläche 34 auf, wobei mittels der Hauptschleiffläche 32 mehr Material als mit der Nebenschleiffläche 34 von dem Spendersubstrat 2 entfernt wird.

Die in Fig. 2 gezeigten Schleifwerkzeuge 22 und die durch die gezeigten Schleifwerkezeuge 22 erzeugten Vertiefungen, können ebenfalls hinsichtlich den in Fig. 1 gezeigten Darstellungen verwendet werden.

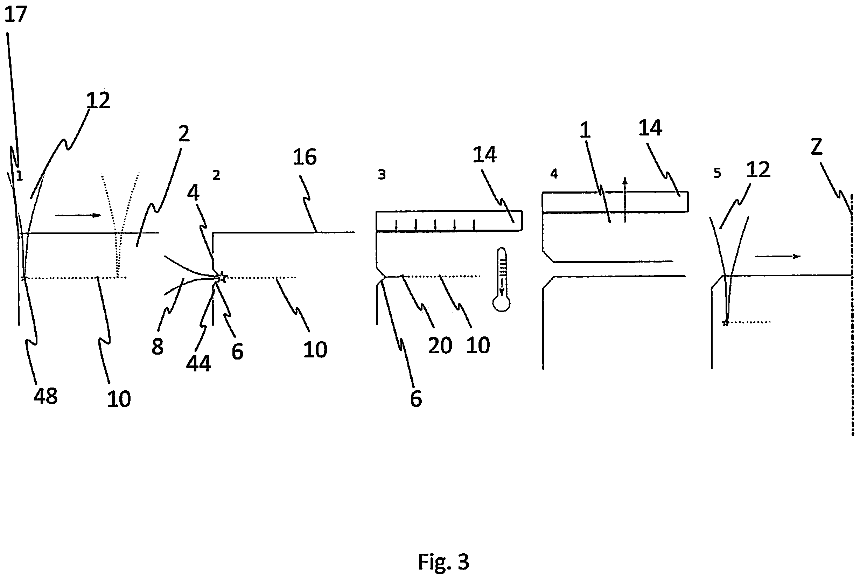

Fig. 3 zeigt eine weitere Variante des Verfahrens. Es kann durch einen Vergleich der ersten und der fünften Darstellung erkannt werden, dass die mittels den LASER-Strahlen 12 erzeugten Modifikationen 10 im Falle einer ebenen Oberfläche 16 näher zum Rand 44 hin erzeugt werden können, als wenn die Kante 17 der Oberfläche 16 entfernt ist, wie dies in der fünften Darstellung gezeigt ist. Die LASER-Strahlen 12 dringen hierbei analog zur bzgl. Fig.1 erläuterten Modifikationserzeugung in das Spendersubstrat 2 ein.

Die zweite Darstellung der Fig. 3 zeigt die Erzeugung einer Vertiefung 6 ausgehend von einer umlaufenden Oberfläche 4 in Richtung Zentrum Z des Spendersubstrats 2, wobei die Vertiefung mittels Ablations-LASER-Strahlen 8 eines Ablations-LASERS (nicht gezeigt) erzeugt wird. Bevorzugt verdampfen die Ablations-LASER-Strahlen 8 hierbei zum Erzeugen der Vertiefung 6 das Material des Spendersubstrats 2.

Darstellung 3 der Fig. 3 entspricht im Wesentlichen der Darstellung 3 der Fig. 2, wobei lediglich die Form der Vertiefung hierbei nicht unsymmetrisch, sondern symmetrisch erzeugt ist. Somit wird ebenfalls gemäß dieser Darstellung eine Spannungserzeugungsschicht 14 an dem Spendersubstrat 2 erzeugt oder angeordnet und zum Erzeugen von mechanischen Spannungen zum Auslösen eines Risses 20 thermisch beaufschlagt, insbesondere mittels flüssigem Stickstoff.

Darstellung 4 der Fig. 3 zeigt die vom Spendersubstrat 2 abgespaltete Festkörperscheibe 1, an der weiterhin die Spannungserzeugungsschicht angeordnet ist.

Der Darstellung 5 der Fig. 3 lässt sich weiter entnehmen, dass bei einem Spendersubstrat 2 dessen Kante 17 bearbeitet ist, die mittels Ablations-LASER-Strahlen 8 zu erzeugende Vertiefung 6 weiter in Richtung Zentrum des Spendersubstrats 2 hineinreichen muss, als wenn die Kante 17 nicht bearbeitet ist. Es ist hierbei jedoch ebenfalls vorstellbar, dass die Vertiefung nicht mittels Ablations-LASER-Strahlen 8, sondern mittels eines Schleifwerkzeugs 22 (wie es z.B. aus dem Figuren 1 und 2 bekannt ist) erzeugt wird.

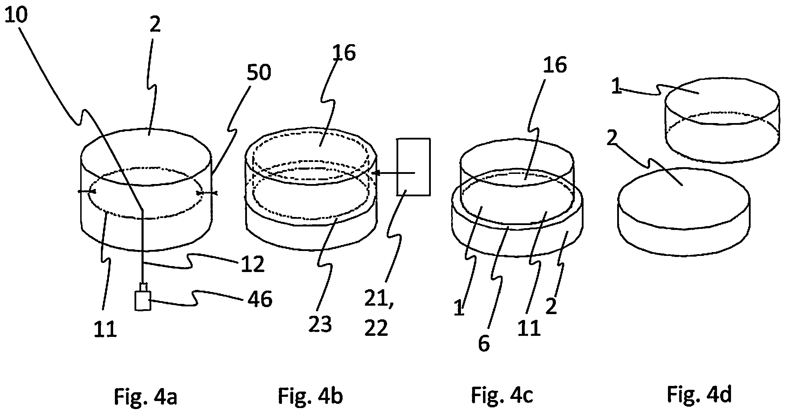

Fig. 4a zeigt eine zusätzliche oder alternative Lösung zum Abtrennen von Festkörperschichten 1 oder Festkörperlagen 1 von einem Spendersubstrat 2. Gemäß Fig. 4a erfolgt die Erzeugung eines Ablösebereichs 11 im inneren des Spendersubstrats 2. Die Modifikationen 10 sind dabei bevorzugt zu einer umlaufenden Begrenzungsfläche 50 des Spendersubstrats 2 beabstandet. Bevorzugt werden die Modifikationen 10 analog zur Darstellung 2 der Fig. 1 erzeugt. Es ist hierbei denkbar, dass die LASER-Strahlen 12 von unten oder von oben, d.h. über die Oberfläche 16 in das Spendersubstrat 2 eingeleitet werden.

Fig. 4b zeigt schematisch die Bearbeitung des Spendersubstrats 2 mittels eines Ablationswerkezug 22, insbesondere einem Werkzeug zum spanenden Bearbeiten des Spendersubstrats 2, wie einem Schleifwerkzeug 22. Durch die Bearbeitung wird zumindest abschnittsweise in Umfangsrichtung des Spendersubstrats 2 Material im gesamten Bereich zwischen dem Ablösebereich und einer zum Ablösebereich bevorzugt homogen, insbesondere parallel, beabstandeten Oberfläche des Spendersubstrats 2 zur Reduzierung der radialen Erstreckung des Spendersubstrats 2 abgetragen. Bevorzugt wird das Material ringförmigt, insbesondere mit einer konstanten oder im Wesentlichen konstanten radialen Ausdehnung, entfernt.

Fig. 4c zeigt ein Beispiel für einen Zustand nach dem Abtrag des Materials. Es ist hierbei z.B. denkbar, dass das Material in axialer Richtung des Spendersubstrats 2 bis auf die Ablöseebene oder darunter oder darüber abgetragen wird.

Fig. 4d zeigt einen Zustand nach dem Abtrennen bzw. Ablösen der Festkörperlage 1 von dem Spendersubstrat 2.

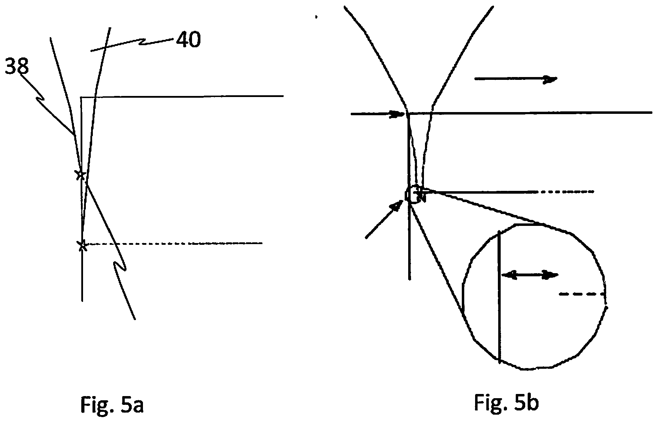

Die Figuren 5a und 5b zeigen ein bei der Erzeugung von Modifikationen mittels LASER-Strahlen 12 auftretendes Problem im Randbereich des Spendersubstrats 2. Durch die unterschiedlichen Brechindizes in der Luft und im Spendersubstrat treffen die LASER-Strahlanteile 38, 40 eines LASER-Strahls 12 nicht genau zusammen, wodurch ungewünschte Effekte, wie die Erzeugung von Defekten an ungewünschten Orten, eine ungewünschte lokale Aufheizung oder ein Verhinderung einer Modifikationserzeugung.

Fig. 5b zeigt, dass eine problemlose Erzeugung von Modifikationen 10 erst erfolgen kann, wenn die zu erzeugende Modifikation 10 soweit von der umlaufenden Oberfläche des Spendersubstrats 2 entfernt ist, dass beide LASER-Strahlanteile 38, 40 jeweils durch Material mit demselben Brechungsindex und bevorzugt über die gleiche Weglänge gebrochen werden. Dies führt jedoch dazu, dass die Modifikationserzeugung, wie sie im zum Randbereich beabstandeten Bereich erfolgt, nicht ohne weiteres auf den Randbereich erstreckt werden kann.

Das Verfahren umfasst dabei die Schritte:
Bereitstellen eines Spendersubstrats 2, Abtragen von Material des Spendersubstrats 2 ausgehend von einer sich in Umfangsrichtung des Spendersubstrats 2 erstreckenden Oberfläche 4 in Richtung Zentrum Z des Spendersubstrats 2 zum Erzeugen einer Vertiefung 6, wobei das Material mittels Ablations-LASER-Strahlen 8 entfernt wird und die Vertiefung 6 asymmetrisch erzeugt wird, Erzeugen von Modifikationen 10 im Inneren des Spendersubstrats 2 mittels weiterer LASER-Strahlen 12, wobei die Modifikationen 10 derart positioniert werden, dass sie sich an die Vertiefung 6 anschließen, wobei sich die Festkörperscheibe 1 durch die erzeugten Modifikationen 10 von dem Spendersubstrat 2 ablöst oder eine Spannungserzeugungsschicht 14 an einer zur umlaufenden Oberfläche geneigt ausgerichteten, insbesondere ebenen, Oberfläche 16 des Spendersubstrats 2 erzeugt oder angeordnet wird und durch ein thermisches Beaufschlagen der Spannungserzeugungsschicht 14 mechanische Spannungen in dem Spendersubstrat 2 erzeugt werden, wobei durch die mechanischen Spannungen ein Riss 20 zum Abtrennen einer Festkörperschicht 1 entsteht, der sich ausgehend von der Vertiefung 6 entlang der Modifikationen 10 ausbreitet.

Das Verfahren umfasst dabei die Schritte:
Erzeugen von Modifikationen 10 im Inneren des Spendersubstrats 2 mittels LASER-Strahlen 12, wobei durch die Modifikationen 10 ein Ablösebereich vorgegeben wird, entlang dem eine Abtrennung der Festkörperlag 1 von dem Spendersubstrat 2 erfolgt,
Abtragen von Material des Spendersubstrats 2 ausgehend von einer sich in Umfangsrichtung des Spendersubstrats 2 erstreckenden Oberfläche 4 in Richtung Zentrum Z des Spendersubstrats 2, insbesondere zum Erzeugen einer umlaufenden Vertiefung 6, wobei durch den Materialabtrag der Ablösebereich freigelegt wird, Abtrennen der Festkörperlage von dem Spendersubstrat, wobei das Spendersubstrat im Ablösebereich durch die Modifikationen derart geschwächt wird, dass sich die Festkörperlage 1 infolge des Materialabtrags von dem Spendersubstrat 2 ablöst oder nach dem Materialabtrag eine solche Anzahl an Modifikationen erzeugt wird, dass das Spendersubstrat im Ablösebereich derart geschwächt wird, dass sich die Festkörperlage 1 von dem Spendersubstrat 2 ablöst oder eine Spannungserzeugungsschicht 14 an einer zur umlaufenden Oberfläche geneigt ausgerichteten, insbesondere ebenen, Oberfläche 16 des Spendersubstrats 2 erzeugt oder angeordnet wird und durch ein thermisches Beaufschlagen der Spannungserzeugungsschicht 14 mechanische Spannungen in dem Spendersubstrat 2 erzeugt werden, wobei durch die mechanischen Spannungen ein Riss 20 zum Abtrennen einer Festkörperlage 1 entsteht, der sich ausgehend von der durch den Materialabtrag freigelegten Oberfläche des Spendersubstrats entlang der Modifikationen 10 ausbreitet.

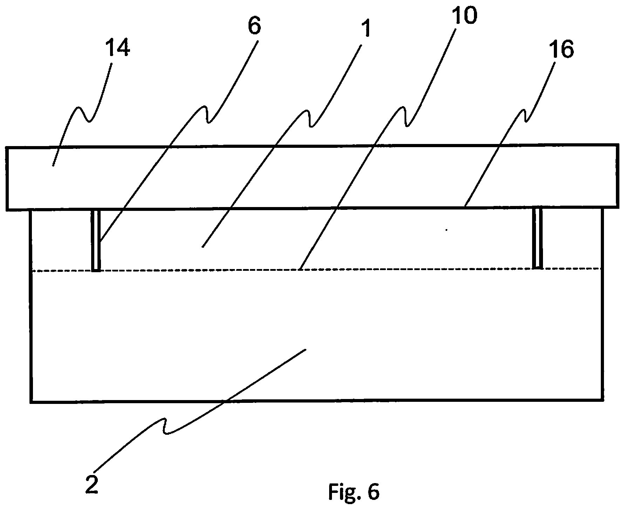

Fig. 6 zeigt schematisch eine Anordnung, gemäß der die Spannungserzeugungsschicht 14 bevorzugt mindestens eine Vertiefung 6, insbesondere Ausnehmung oder Graben, die sich bevorzugt ausgehend von einer ebenen bzw. im Wesentlichen ebenen Oberfläche 16 in Richtung einer zur ebenen Oberfläche 16 bevorzugt parallelen weiteren Oberfläche des Festkörpers 2 hin erstreckt, überlagert bzw. überdeckt bzw. verschließt.

Die Spannungserzeugungsschicht 14 wird bevorzugt als Polymerschicht erzeugt bzw. wird als Schicht erzeugt, die zu überwiegenden Massen- und/oder Volumenanteilen aus mindestens einem Polymermaterial besteht. Die Oberfläche 16, an der die Spannungserzeugungsschicht 14 angeordnet wird, weist bevorzugt behandelte Anteile auf. Als behandelte Anteile werden hierbei bevorzugt Anteile verstanden, in denen Material abgetragen wurde. Bevorzugt erstrecken sich somit ausgehende von der Oberfläche 16, an der die Spannungserzeugungsschicht 14 angeordnet wird und die sich bevorzugt im Wesentlichen oder vollständig parallel zu einer aus Modifikationen 10 gebildeten Rissführungsschicht erstreckt, Vertiefung/en, insbesondere Ausnehmungen 6 und/oder Gräben 6, bevorzugt orthogonal zur Oberfläche und/oder zur Rissführungsschicht. Es ist hierbei alternativ denkbar, dass nur eine Vertiefung 6, insbesondere ein Graben und/oder eine Ausnehmung, mittels Materialabtrag erzeugt wurde und/oder ausgebildet ist. Der Materialabtrag wird bevorzugt vor der Erzeugung oder Anbringung der Spannungserzeugungsschicht 14 an der Oberfläche 16 bewirkt, insbesondere mittels Laserablation. Die Spannungserzeugungsschicht 14 überdeckt im mit dem Festkörper 2 gekoppelten bzw. verbundenen Zustand die Vertiefung/en 6, insbesondere den Graben bzw. die Gräben oder die Ausnehmung bzw. die Ausnehmungen.

Bevorzugt erfolgt zwischen der Erzeugung der Vertiefung 6, insbesondere der Ausnehmung und/oder des Grabens, und der Anbringung der Spannungserzeugungsschicht keine weitere Beschichtung, insbesondere kein weiterer Materialauftrag. Dies ist vorteilhaft, da sich sonst Material in der Ausnehmung/Graben ansammeln könnte.

Bevorzugt erfolgt die Anbringung der Spannungserzeugungsschicht mittels eines Plasma-Laminationsprozesses. Dies ist vorteilhaft, das so über die Vertiefung 6, insbesondere Ausnehmung/Graben, hinweg eine Verbindung zwischen dem Festkörper 1, insbesondere der Hauptoberfläche 16 der späteren Festkörperschicht 1, und der Spannungserzeugungsschicht 14 erzeugt werden kann. Die Verbindung stellt bevorzugt ein Laminieren oder Kleben dar. Bevorzugt wird dies unter Verwendung von Kaltplasma umgesetzt.

Zusätzlich oder alternativ kann erfindungsgemäß ein "Spontansplit" mit zuvor erzeugter Laserebene bzw. Rissführungsebene und Tiefenmodifikation durch einen Materialabtragungsschritt, insbesondere Laserablation, bewirkt werden. Bevorzugt wird dies ohne Spannungserzeugungsschicht 14 bewirkt.

Die Spannungserzeugungsschicht 14 kann auch als Stressorschicht, insbesondere als selbsttragende Stressorschicht, bezeichnet werden.

Erfindungsgemäß wurde ferner erkannt, dass eine selbsttragende Stressorschicht gegenüber einer aufgedampften oder anderweitig durch Abscheidung aufgebrachten Stressorschicht von entscheidendem technischem Vorteil ist, da solche Stressorschichten zum einen in größerem Volumen in einfacheren Verfahren in spezialisierten Anlagen mit höherem Durchsatz hergestellt werden können und zum anderen in Laminationsprozessen eingesetzt werden können, die ebenfalls höhere Prozessgeschwindigkeiten erlauben. Zusätzlich können selbsttragende Stressorschichten nach Laminationsprozessen auch unter geringem Aufwand wieder vom Substrat abgelöst werden, was zum Beispiel auch eine Wiederverwendung, d.h. der Stressorschicht bzw. der Spannungserzeugungsschicht, erlaubt, die mit abgeschiedenen Schichten unmöglich ist.

Besonders vorteilhaft ist, dass Laminationsprozesse auch ohne Klebeverfahren oder ähnliches rein durch eine Oberflächenaktivierung, Oberflächenbehandlung oder Oberflächenmodifikation des Substrates realisiert werden können. Somit erfolgt eine Kopplung bzw. Verbindung der Spannungserzeugungsschicht mit dem Festkörper, insbesondere mit der Oberfläche 16 der späteren Festkörperschicht 1, besonders bevorzugt durch eine Oberflächenaktivierung und/oder Oberflächenbehandlung und/oder Oberflächenmodifikation des Festkörpers bzw. der Oberfläche 16 der späteren Festkörperschicht 1.

So kann die Oberfläche z.B. bevorzugt durch Kontakt mit, insbesondere in einer Kammer, erzeugtem Ozon und/oder durch ultraviolettes Licht einer bestimmten Wellenlänge und/oder durch Plasmaverfahren mit unterschiedlichen gebildeten Spezies an den Oberflächen des Substrats und/oder der Stressorschicht und/oder im Prozessgas, insbesondere radikalische, Aldehyd-, und Alkohol-Spezies, aktiviert werden. Hier werden insbesondere Heißplasma-Verfahren bevorzugt, bei denen hohe Temperaturen Anwendung finden, um freie Ladungsträger und Radikale im Plasma zu erzeugen, was für die daraus folgenden Reaktionen an den Oberflächen von Substrat und Stressorschicht andere Reaktionspfade und chemische Oberflächenreaktionen erlaubt als bei niedrigeren Temperaturen. Der Oberflächenmodifikationsmechanismus kann sich also temperaturabhängig unterscheiden, ebenso zwischen verschiedenen Substraten, wobei z.B. bei SiC im Gegensatz zu Si, die beteiligten Kohlenstoffatome andere Oberflächenspezies in der Plasmabehandlung ausbilden können, die im Laminationsprozess ebenfalls haftvermittelnd wirken können.

Alternativ ist der Einsatz eines Kaltplasma-Verfahrens möglich, bei dem ein Plasma nicht durch Glühemission und über heiße Wolfram-Filamente oder ähnliche Methoden erzeugt wird, sondern über piezoelektrische Transformatoren bei atmosphärischem Druck und bevorzugt ohne erhöhte Temperaturen. Diese niedrigeren Temperaturen vermindern und/oder verändern ebenfalls die zur Verfügung stehenden Reaktionspfade für Oberflächenaktivierungen und Oberflächenmodifikationen zur Haftvermittlung in Laminationsprozessen, sowohl am Substrat bzw. dem Festkörper als auch an der Stressorschicht. Die entstandenen Oberflächenspezies hängen also von einer Vielzahl von Parametern und der Oberflächenaktivierungsmethode im Besonderen ab.

Die Oberflächenbehandlung bzw. -modifikation umfasst beispielsweise die zumindest abschnittsweise Beaufschlagung der zu behandelnden Oberfläche durch eine Koronabehandlung und/oder durch eine Flammbehandlung und/oder durch eine Behanldung mittels elektrischer Barriereentladung und/oder durch Fluorierung und/oder durch Ozonierung und/oder durch Eximerbestahlung und/oder durch eine Behandlung mit einem Plasma, wobei bevorzugt einzelne oder mehrere physikalische Parameter, wie die Art des Plasmas, der Spurabstand bei der Plasmabehandlung, die Düsenart, der Düsenabstand und/oder die Dauer der Plasmabehandlung, variiert werden bzw. variierbar sind.

Bevorzugt wird eine Plasmavorbehandlung bzw. Plasmabehandlung sowohl zu einer Reinigung als auch anschließend zu einer Homogenisierung der Oberflächenspezies herangezogen (z.B. Hydrophobierung u.a.).

Mittels einer gezielten individuellen Plasmabehandlung ist eine ortsaufgelöste Variation der Oberflächenaktivierung erzeugbar bzw. einstellbar, die anschließend eine Lamination der Stressorschicht erlaubt - ebenfalls mit ortsveränderlichen Eigenschaften, wenn gewünscht.

Der Prozess der Plasmaoberflächenaktivierung bzw. der Plasmaoberflächenbehandlung gestattet eine größere Einflussnahme, um die gewünschte differenzierte Haftung bzw. Kraftübertragung nach der Lamination der Stressorschicht auf dem Substrat auch auf großen Flächen in einer definierten symmetrischen oder aber asymmetrischen Form aufzubringen. Hierbei kann durch Prozessvariation gezielt, insbesondere lokal, eine geänderte Adhäsion oder Kohäsion eingestellt werden. In Abhängigkeit der Ausgangseigenschaften der unterschiedlichen Festkörpermaterialien, insbesondere Halbleitermaterialien, können Schichten aufgebracht und/oder durch weitere graduelle Prozessgase (Sauerstoff, u.a.) die gewünschten Zusatzschicht/en, insbesondere Opfer/Schadschichten oder Substrat- und/oder Stressorschicht-Oberflächen, gezielt modifiziert werden (hydrophob, hydrophil, Benetzung etc.). Dies führt zu einer ortaufgelösten angepassten graduellen Haftung bzw. ortaufgelöst angepassten oder eingestellten Kraftübertragungsverbindung, auch in Laminationsprozessen, was gegenüber der durch Klebe- und Abscheidelösungen für die Stressorschicht nur homogen und nicht ortsaufgelöst.

Wie bereits beschrieben können unterschiedliche physikalische Parameter während der Plasmabehandlung zum Einsatz kommen (z.B. Art des Plasmas, Spurabstand bei der Plasmabehandlung, Düsenart, Düsenabstand, Dauer der Plasmabehandlung). Zusätzlich zu diesen Einflussparametern kann durch eine gezielte Beimischung von graduellen Prozessgasen wie z.B. Stickstoff, Sauerstoff, Wasserstoff, SiH4, Si(EtO)4 oder Me3SiOSiMe3 (u.a.) eine größere Bandbreite der notwendigen Oberflächeneigenschaften herbeigeführt werden. Diese resultieren bevorzugt aus neuen chemischen Oberflächenspezies, die sich auf der Halbleiteroberfläche und/oder den sich anschließenden Opferschichten und/oder der Stressorschicht abscheiden und so eine unterschiedlich ausgebildete Oberflächenfunktionalität und Laminationsprozesseigenschaften ermöglichen. Dies führt zu den gewünschten Zielprofilen, wie zum Beispiel unterschiedliche ortsaufgelöste Adhäsions- und Kohäsionseigenschaften, der Halbleiteroberflächen und/oder den sich anschließenden Stressor- und/oder anderen Schichten.

Eine Korona-Behandlung ist ein elektrochemisches Verfahren zur Oberflächenbehandlung bzw. -modifikation von Kunststoffen. Hierbei wird die Oberfläche einer elektrischen Hochspannungs-Entladung ausgesetzt. Eine Koronabehandlung wird z.B. zur Haftvermittlung bei Kunststoffen, Folien u.a. (PE, PP) verwendet.

Bei einer Flammenbehandlung kommt vor allem eine oberflächennahe Oxidation der jeweiligen Verbindungen zum Tragen. Im Wesentlichen erfolgen Oxidationsprozesse, durch die je nach Material und Versuchsbedingungen verschiedene polare funktionelle Gruppen gebildet werden (z.B. Oxide, Alkohole, Aldehyde, Carbonsäuren, Ester, Ether, Peroxide).

Eine Behandlung durch dielektrische Barriereentladung (DBE, Wechselspannungs-Gasentladung, dieelectric barrier discharge, auch DBD Behandlung) ist einem Niedertemperaturplasma bzw. einer Glimmentladung (z.B. GDMS) ähnlich. Bei der DBE-Behandlung wird die Oberfläche mit uni- oder bipolaren Pulsen mit Pulsdauern von wenigen Mikrosekunden bis hinunter zu einigen zehn Nanosekunden und Amplituden im einstelligen Kilovoltbereich beaufschlagt. Eine dielektrische Barriereentladung ist vorteilhaft, da hierbei keine metallischen Elektroden im Entladungsraum und somit keine metallischen Verunreinigungen oder Elektrodenverschleiß zu erwarten sind.

Weitere Vorteile der dielektrische Barriereentladung können je nach Anwendung z.B. sein, dass sie eine hohe Effizienz aufweist, da an den Elektroden keine Ladungsträger aus- oder eintreten müssen (Wegfall des Kathodenfalls, keine Glühemission nötig) oder dass die dielektrischen Oberflächen bei niedrigen Temperaturen modifiziert und chemisch aktiviert werden können. Die Oberflächenmodifikation erfolgt dabei bevorzugt durch eine Wechselwirkung und Reaktion der Oberflächenspezies durch ein Ionenbombardement und der Einwirkung der Ultraviolettstrahlung auf die Oberflächenspezies (z.B. 80nm - 350nm, inkohärentes Licht UV und VUV, durch Leistungs-Hochfrequenzgeneratoren). Die dielektrische Barriereentladung findet z.B. Anwendung zur in situ Herstellung von Ozon in der Trink- / Abwasseraufbereitung, wobei durch das Ozon eine Ozonierung des Wassers erfolgt. Analog hierzu erfolgt bei einer erfindungsgemäßen Oberflächenbehandlung oder - modifikation mittels Ozonierung eine Beaufschlagung der zu behandelnden Oberfläche mittels Ozon.

Eine Oberflächenbehandlung bzw. -modifikation mittels Halogenierung, insbesondere Fluorierung, bewirkt die Überführung eines Elementes oder einer Verbindung in ein Halogenid. Durch die Fluorierung erfolgt somit die Einführung von Fluor in bevorzugt organische Verbindungen mit Hilfe von Fluorierungsmitteln.

Eine Oberflächenbehandlung bzw. -modifikation mittels einer UV-Behandlung erfolgt bevorzugt durch eine Eximer Bestrahlung oder durch ultraviolette Leuchtdiodenquellen, z.B. auf Aluminiumnitrid-Basis. Eine Eximerbestrahlung erfolgt durch die Verwendung von mindestens einem Excimerlaser. Eximerlaser sind Gaslaser, die elektromagnetische Strahlung im ultravioletten Wellenlängenbereich erzeugen können. Eine hierbei erfolgende Gasentladung wird somit durch ein elektromagnetisches Hochfrequenzfeld hervorgerufen. Deshalb werden auch keine Elektroden bei der Gasentladung benötigt. Die erzeugte UV.Strahlung, liegt bevorzugt in einem Wellenlängenbereich zwischen 120 nm und 380 nm.

**Bezugszeichenliste**

| | | | |
|---|---|---|---|
| 1 | Festkörperscheibe | 18 | Vertiefungsende |
| 2 | Spendersubstrat | 20 | Riss |
| 4 | in Umfangsrichtung erstreckende Oberfläche | 21 | Ablationswerkzeug |
| 6 | Vertiefung | 22 | Schleifwerkzeug |
| 8 | Ablations-LASER-Strahlen | 23 | Ring |
| 10 | Modifikationen | 24 | erster Bearbeitungsanteil |
| 11 | Ablösebereich | 26 | zweiter Bearbeitungsanteil |
| 12 | weitere LASER-Strahlen | 28 | Unterseite |
| 14 | Spannungserzeugungsschicht | 30 | Oberseite |
| 16 | ebene Oberfläche | 32 | Hauptschleiffläche |
| 17 | Kante | 34 | Nebenschleiffläche |
| | | 36 | erster Anteil an LASER-Strahlen |
| 38 | erster Winkel | 46 | LASER-Einrichtung |
| 40 | weiterer Anteil | 48 | LASER-Fokus |
| 42 | zweiter Winkel | 50 | Umlaufende Begrenzungsfläche |
| 44 | Rand | | |

## Patentansprüche

1. Verfahren zum Abtrennen von mindestens einer Festkörperlage, insbesondere einer Festkörperscheibe, (1) von einem Spendersubstrat (2),
mindestens umfassend die Schritte:
Bereitstellen eines Spendersubstrats (2),
Erzeugen von Modifikationen (10) im Inneren des Spendersubstrats (2) mittels LASER-Strahlen (12), wobei durch die Modifikationen (10) ein Ablösebereich vorgegeben wird, entlang dem eine Abtrennung der Festkörperlage (1) von dem Spendersubstrat (2) erfolgt,
**gekennzeichnet durch** :
Abtragen von Material des Spendersubstrats (2) ausgehend von einer sich in Umfangsrichtung des Spendersubstrats (2) erstreckenden Oberfläche (4) in Richtung Zentrum (Z) des Spendersubstrats (2), zum Erzeugen einer umlaufenden Vertiefung (6) mit einer asymmetrischen Gestalt, wobei durch den Materialabtrag der Ablösebereich freigelegt wird,
Abtrennen der Festkörperlage von dem Spendersubstrat,
wobei das Spendersubstrat im Ablösebereich durch die Modifikationen derart geschwächt wird, dass sich die Festkörperlage (1) infolge des Materialabtrags von dem Spendersubstrat (2) ablöst
oder
eine Spannungserzeugungsschicht (14) an einer zur umlaufenden Oberfläche geneigt ausgerichteten, insbesondere ebenen, Oberfläche (16) des Spendersubstrats (2) erzeugt oder angeordnet wird und durch ein thermisches Beaufschlagen der Spannungserzeugungsschicht (14) mechanische Spannungen in dem Spendersubstrat (2) erzeugt werden, wobei durch die mechanischen Spannungen ein Riss (20) zum Abtrennen einer Festkörperlage (1) entsteht, der sich ausgehend von der durch den Materialabtrag freigelegten Oberfläche des Spendersubstrats entlang der Modifikationen (10) ausbreitet.

2. Verfahren nach Anspruch 1,
**dadurch gekennzeichnet, dass**
der durch die Modifikationen (10) vorgegebene Ablösebereich vor dem Materialabtrag weiter zur umlaufenden Oberfläche des Spendersubstrats (2) beabstandet ist als nach dem Materialabtrag.

3. Verfahren nach Anspruch 1 oder Anspruch 2,
**dadurch gekennzeichnet, dass**
die Modifikationen (10) zum Vorgeben des Ablösebereichs vor dem Materialabtrag erzeugt werden und durch den Materialabtrag zumindest stellenweise eine Reduzierung des Abstands des Ablösebereichs auf weniger als 10mm, insbesondere auf weniger als 5mm und bevorzugt auf weniger als 1mm, erreicht wird.

4. Verfahren nach einem der vorangegangenen Ansprüche,
**dadurch gekennzeichnet, dass**
das Material mittels Ablations-LASER-Strahlen entfernt wird.

5. Verfahren nach Anspruch 4,
**dadurch gekennzeichnet, dass**
die Vertiefung (6) das Spendersubstrats (2) vollständig in Umfangsrichtung umgibt.

6. Verfahren nach Anspruch 4 oder Anspruch 5,
**dadurch gekennzeichnet, dass**
die Vertiefung (6) in Richtung Zentrum (Z) bis zu einem Vertiefungsende (18) hin enger werdend, insbesondere keilförmig, verläuft, wobei das Vertiefungsende (18) in der Ebene liegt, in der sich der Riss (20) ausbreitet.

7. Verfahren nach einem der vorangegangenen Ansprüche,
**dadurch gekennzeichnet, dass**
die asymmetrische Vertiefung (6) mittels einem zur Vertiefung (6) zumindest abschnittsweise negativ geformten Schleifwerkzeug (22) erzeugt wird.

8. Verfahren nach Anspruch 7,
**dadurch gekennzeichnet, dass**
das Schleifwerkzeug (22) mindestens zwei verschieden geformte Bearbeitungsanteile (24, 26) aufweist, wobei ein erster Bearbeitungsanteil (24) zum Bearbeiten des Spendersubstrats (2) im Bereich der Unterseite (28) einer abzutrennenden Festkörperscheibe (1) und ein zweiter Bearbeitungsanteil (26) zum Bearbeiten des Spendersubstrats (2) im Bereich der Oberseite (30) der von dem Spendersubstrat (2) abzutrennenden Festkörperscheibe (1) bestimmt ist.

9. Verfahren nach Anspruch 8,
**dadurch gekennzeichnet, dass**
der erste Bearbeitungsanteil (24) eine tiefere oder volumenmäßig größere Vertiefung (6) in dem Spendersubstrat (2) erzeugt als der zweite Bearbeitungsanteil (26), wobei der erste Bearbeitungsanteil (24) und/oder der zweite Bearbeitungsanteil (26) gebogene oder gerade Schleifflächen (32, 34) aufweisen.

10. Verfahren nach Anspruch 9,
**dadurch gekennzeichnet, dass**
der erste Bearbeitungsanteil (24) eine gebogene Hauptschleiffläche (32) aufweist und der zweite Bearbeitungsanteil (26) eine gebogene Nebenschleiffläche (34) aufweist, wobei der Radius der Hauptschleiffläche (32) größer ist als der Radius der Nebenschleiffläche (34), bevorzugt ist der Radius der Hauptschleiffläche (32) mindestens doppelt so groß, wie der Radius der Nebenschleiffläche (34)
oder
der erste Bearbeitungsanteil (24) eine gerade Hauptschleiffläche (32) aufweist und der zweite Bearbeitungsanteil (26) eine gerade Nebenschleiffläche (34) aufweist, wobei mittels der Hauptschleiffläche (32) mehr Material als mit der Nebenschleiffläche (34) von dem Spendersubstrat (2) entfernt wird
oder
der erste Bearbeitungsanteil (24) eine gerade Hauptschleiffläche(32) aufweist und der zweite Bearbeitungsanteil (26) eine gebogene Nebenschleiffläche (34) aufweist
oder
der erste Bearbeitungsanteil (24) eine gebogene Hauptschleiffläche (32) aufweist und der zweite Bearbeitungsanteil (26) eine gerade Nebenschleiffläche (34) aufweist.

11. Verfahren nach einem der vorangegangenen Ansprüche,
**dadurch gekennzeichnet, dass**
die Ablations-LASER-Strahlen (8) mit einer Wellenlänge im Bereich zwischen 300 nm und 10 µm, mit einer Pulsdauer von weniger als 100 Mikrosekunden und bevorzugt von weniger als 1 Mikrosekunde und besonders bevorzugt von weniger als 1/10 Mikrosekunde und mit einer Pulsenergie von mehr als 1µJ und bevorzugt von mehr als 10 µJ erzeugt werden.

12. Verfahren nach Anspruch 4,
**dadurch gekennzeichnet, dass**
das im gesamten Bereich zwischen dem Ablösebereich und der zum Ablösebereich homogen beabstandeten Oberfläche abzutragende Material eine ringförmige, insbesondere zylinderförmige, Gestalt beschreibt.

13. Verfahren nach einem der vorangegangenen Ansprüche 1 bis 8,
**dadurch gekennzeichnet, dass**
wobei die LASER-Strahlen (12) von einer LASER-Einrichtung (46) emittiert werden,
wobei die LASER-Einrichtung (46) ein Picosekundenlaser oder ein Femtosekundenlaser ist
und/oder
die Energie der LASER-Strahlen (12), insbesondere des fs-LASER, derart gewählt wird, dass die Schädigungsausbreitung einer jeden Modifikation (10) in dem Spendersubstrat (2) kleiner als 3 mal die Rayleighlänge, bevorzugt kleiner als die Rayleighlänge und besonders bevorzugt kleiner ein Drittel mal die Rayleighlänge ist
und/oder
die Wellenlänge der LASER-Strahlen (12), insbesondere des fs-LASER, derart gewählt wird, dass die Absorption des Spendersubstrats (2) kleiner als 10cm⁻¹ und bevorzugt kleiner als 1cm⁻¹ und besonders bevorzugt kleiner als 0,1cm⁻¹ ist
und/oder
sich die einzelnen Modifikationen (10) jeweils in Folge einer von den LASER-Strahlen (12), insbesondere des fs-LASER, bewirkten multi-photonen Anregung ergeben.

14. Verfahren nach Anspruch 1 bis 9,
**dadurch gekennzeichnet, dass**
die LASER-Strahlen (12) zum Erzeugen der Modifikationen (10) über eine Oberfläche (16) in den Spenderwafer (2) eindringen, die Bestandteil der abzutrennenden Festkörperscheibe (1) ist.

15. Verfahren nach einem der vorangegangenen Ansprüche,
**dadurch gekennzeichnet, dass**
die Spannungserzeugungsschicht (14) ein Polymer, insbesondere Polydimethylsiloxan (PDMS), aufweist oder daraus besteht, wobei die thermische Beaufschlagung derart erfolgt, dass das Polymer einen Glasübergang erfährt, wobei die Spannungserzeugungsschicht (14), insbesondere mittels flüssigem Stickstoff, auf eine Temperatur unterhalb der Raumtemperatur oder unterhalb von 0°C oder unterhalb von -50°C oder unterhalb von - 100°C oder unterhalb von -110°C, insbesondere auf eine Temperatur unterhalb der Glasübergangstemperatur der Spannungserzeugungsschicht (14), temperiert wird.

16. Verfahren nach einem der vorangegangenen Ansprüche,
**dadurch gekennzeichnet, dass**
die Ablations-Strahlung beschleunigte Ionen und/oder Plasma und/oder LASER-Strahlen umfasst und/oder durch Elektronenstrahlheizen oder Ultraschallwellen gebildet wird und/oder Bestandteil eines lithografischen Verfahrens (Elektronenstrahl, UV, Ionen, Plasma) mit mindestens einem Ätzschritt nach zuvor erfolgter Fotolackbeschichtung ist und/oder das Ablations-Fluid ein Flüssigkeitsstrahl, insbesondere ein Wasserstrahl eines Wasserstrahlschneidprozesses, ist.

## Claims

1. Method for separating at least one solid-state layer, in particular a solid-state wafer, (1) from a donor substrate (2),
at least comprising the following steps:
providing a donor substrate (2),
producing modifications (10) in the interior of the donor substrate (2) by means of LASER beams (12),
wherein a detachment region is predefined by the modifications (10), along which detachment region the solid-state layer (1) is separated from the donor substrate (2),
**characterized by**:
removing material of the donor substrate (2) proceeding from a surface (4), extending in the circumferential direction of the donor substrate (2), in the direction of the centre (Z) of the donor substrate (2), in order to produce a circumferential depression (6) having an asymmetrical shape, wherein the detachment region is exposed by the material removal,
separating the solid-state layer from the donor substrate,
wherein the donor substrate is weakened by the modifications in the detachment region in such a way that the solid-state layer (1) detaches from the donor substrate (2) on account of the material removal,
or
a stress-inducing layer (14) is produced or arranged at an, in particular planar, surface (16) of the donor substrate (2), said surface being oriented in an inclined manner with respect to the circumferential surface, and mechanical stresses are induced in the donor substrate (2) by means of thermal exposure of the stress-inducing layer (14), wherein the mechanical stresses give rise to a crack (20) for separating a solid-state layer (1), which crack propagates along the modifications (10) proceeding from that surface of the donor substrate which is exposed as a result of the material removal.

2. Method according to Claim 1,
**characterized in that**
the detachment region predefined by the modifications (10) is spaced apart from the circumferential surface of the donor substrate (2) further before the material removal than after the material removal.

3. Method according to Claim 1 or Claim 2,
**characterized in that**
the modifications (10) for predefining the detachment region are produced before the material removal and a reduction of the spacing of the detachment region to less than 10 mm, in particular to less than 5 mm and preferably to less than 1 mm, is achieved at least in places as a result of the material removal.

4. Method according to any of the preceding claims,
**characterized in that**
the material is removed by means of ablation LASER beams.

5. Method according to Claim 4,
**characterized in that**
the depression (6) completely surrounds the donor substrate (2) in the circumferential direction.

6. Method according to Claim 4 or Claim 5,
**characterized in that**
the depression (6) extends in the direction of the centre (Z) as far as a depression end (18) in a manner becoming narrower, in particular in a wedge-shaped manner, wherein the depression end (18) lies in the plane in which the crack (20) propagates.

7. Method according to any of the preceding claims,
**characterized in that**
the asymmetrical depression (6) is produced by means of a grinding tool (22) shaped negatively at least in sections with respect to the depression (6).

8. Method according to Claim 7,
**characterized in that**
the grinding tool (22) has at least two differently shaped processing portions (24, 26), wherein a first processing portion (24) is intended for processing the donor substrate (2) in the region of the underside (28) of a solid-state wafer (1) to be separated and a second processing portion (26) is intended for processing the donor substrate (2) in the region of the top side (30) of the solid-state wafer (1) to be separated from the donor substrate (2).

9. Method according to Claim 8,
**characterized in that**
the first processing portion (24) produces a deeper or volumetrically larger depression (6) in the donor substrate (2) than the second processing portion (26), wherein the first processing portion (24) and/or the second processing portion (26) have/has bent or straight grinding surfaces (32, 34).

10. Method according to Claim 9,
**characterized in that**
the first processing portion (24) has a bent main grinding surface (32) and the second processing portion (26) has a bent secondary grinding surface (34), wherein the radius of the main grinding surface (32) is greater than the radius of the secondary grinding surface (34), preferably the radius of the main grinding surface (32) is at least double the magnitude of the radius of the secondary grinding surface (34), or
the first processing portion (24) has a straight main grinding surface (32) and the second processing portion (26) has a straight secondary grinding surface (34), wherein more material is removed from the donor substrate (2) by means of the main grinding surface (32) than by means of the secondary grinding surface (34),
or
the first processing portion (24) has a straight main grinding surface (32) and the second processing portion (26) has a bent secondary grinding surface (34),
or
the first processing portion (24) has a bent main grinding surface (32) and the second processing portion (26) has a straight secondary grinding surface (34).

11. Method according to any of the preceding claims,
**characterized in that**
the ablation LASER beams (8) are generated with a wavelength in the range of between 300 nm and 10 µm, with a pulse duration of less than 100 microseconds and preferably of less than 1 microsecond and particularly preferably of less than 1/10 microsecond, and with a pulse energy of more than 1 µJ and preferably of more than 10 µJ.

12. Method according to Claim 4,
**characterized in that**
the material to be removed in the entire region between the detachment region and the surface spaced apart homogeneously from the detachment region describes a ring-shaped, in particular cylindrical, shape.

13. Method according to any of the preceding Claims 1 to 8,
**characterized in that**
wherein the LASER beams (12) are emitted by a LASER device (46),
wherein the LASER device (46) is a picosecond laser or a femtosecond laser,
and/or
the energy of the LASER beams (12), in particular of the fs LASER, is chosen in such a way that the damage propagation of each modification (10) in the donor substrate (2) is less than three times the Rayleigh length, preferably less than the Rayleigh length and particularly preferably less than one third of the Rayleigh length,
and/or
the wavelength of the LASER beams (12), in particular of the fs LASER, is chosen in such a way that the absorption of the donor substrate (2) is less than 10 cm⁻¹ and preferably less than 1 cm⁻¹ and particularly preferably less than 0.1 cm⁻¹,
and/or
the individual modifications (10) arise in each case on account of a multi-photon excitation effected by the LASER beams (12), in particular of the fs LASER.

14. Method according to Claims 1 to 9,
**characterized in that**
the LASER beams (12) for producing the modifications (10) penetrate into the donor wafer (2) via a surface (16) that is part of the solid-state wafer (1) to be separated.

15. Method according to any of the preceding claims,
**characterized in that**
the stress-inducing layer (14) comprises or consists of a polymer, in particular polydimethylsiloxane (PDMS), wherein the thermal exposure is effected in such a way that the polymer experiences a glass transition, wherein the stress-inducing layer (14) is temperature-regulated, in particular by means of liquid nitrogen, to a temperature below room temperature or below 0°C or below -50°C or below -100°C or below -110°C, in particular to a temperature below the glass transition temperature of the stress-inducing layer (14).

16. Method according to any of the preceding claims,
**characterized in that**
the ablation radiation comprises accelerated ions and/or plasma and/or LASER beams and/or is formed by electron beam heating or ultrasonic waves and/or is part of a lithographic method (electron beam, UV, ions, plasma) having at least one etching step after photoresist coating carried out previously, and/or the ablation fluid is a liquid jet, in particular a water jet of a water jet cutting process.

## Revendications

1. Procédé de séparation d'au moins une couche à semi-conducteur, notamment d'une plaquette (1) à semi-conducteur, d'un substrat (2) donneur,
comprenant au moins les stades :
on se procure un substrat (2) donneur,
on produit des modifications (10) à l'intérieur du substrat (2) donneur au moyen d'un rayonnement (12) laser, dans lequel, par les modifications (10), on prescrit une région de détachement le long de laquelle a lieu une séparation de la couche (1) à semi-conducteur du substrat (2) donneur, **caractérisé par** :
un enlèvement de matière du substrat (2) donneur à partir d'une surface (4) s'étendant dans la direction de pourtour du substrat (2) donneur en direction du centre (Z) du substrat (2) donneur pour produire une cavité (6) faisant le tour d'une forme dissymétrique,
dans lequel par l'enlèvement de matière, on met à découvert la région de détachement,
une séparation de la couche à semi-conducteur du substrat donneur,
dans lequel on affaiblit par les modifications le substrat donneur dans la région de détachement, de manière à ce que la couche (1) à semi-conducteur se détache du substrat (2) donneur en raison de l'enlèvement de matière
ou
on produit ou on met une couche (14) de production de tension sur une surface (16) inclinée par rapport à la surface faisant le tour, notamment plane, du substrat (2) donneur et en soumettant la couche (4) de production de tension à une charge thermique, on produit des tensions mécaniques dans le substrat (2) donneur, dans lequel par les tensions mécaniques, il se créé une fissure (20) de séparation d'une couche (1) à semi-conducteur qui, à partir de la surface mise à découvert par l'enlèvement de matière du substrat donneur, se propage le long des modifications (10) .

2. Procédé suivant la revendication 1,
**caractérisé en ce que**
la région de détachement prescrite par les modifications (10) est, pendant l'enlèvement de matière, plus loin de la surface faisant le tour du substrat (2) donneur qu'après l'enlèvement de matière.

3. Procédé suivant la revendication 1 ou la revendication 2,
**caractérisé en ce que**
l'on produit les modifications (10) pour prescrire la région de détachement avant l'enlèvement de matière et, par l'enlèvement de matière, on obtient au moins par endroit une réduction de la distance de la région de détachement à moins de 10 mm, notamment à moins de 5mm et de préférence à moins de 1 mm.

4. Procédé suivant l'une des revendications précédentes,
**caractérisé en ce que**
l'on élimine la matière au moyen d'un rayonnement laser d'ablation.

5. Procédé suivant la revendication 4,
**caractérisé en ce que**
la cavité (6) entoure le substrat (2) donneur complètement dans la direction du pourtour.

6. Procédé suivant la revendication 4 ou la revendication 5,
**caractérisé en ce que**
la cavité (6) s'étend en direction du centre (Z) jusqu'à une extrémité (18) de cavité en devenant plus étroite, notamment cunéiforme, l'extrémité (18) de la cavité se trouvant dans le plan dans lequel se propage la fissure (20).

7. Procédé suivant l'une des revendications précédentes,
**caractérisé en ce que**
l'on produit la cavité (6) dissymétrique au moyen d'un outil (22) de meulage conformé de manière négative, au moins par endroit, par rapport à la cavité (6).

8. Procédé suivant la revendication 7,
**caractérisé en ce que**
l'outil (22) de meulage a au moins deux parties (24, 26) d'usinage formées de manière différente, une première partie (24) d'usinage étant destinée à usiner le substrat (2) donneur dans la région de la face (28) inférieure d'une plaquette (1) à semi-conducteur à séparer et une deuxième partie (26) d'usinage étant destinée à usiner le substrat (2) donneur dans la région de la face (30) supérieure de la plaquette (1) à semi-conducteur à séparer du substrat (2) donneur.

9. Procédé suivant la revendication 8,
**caractérisé en ce que**
la première partie (24) d'usinage produit dans le substrat (2) donneur, une cavité (6) plus profonde ou de volume plus grand que la deuxième partie (26) d'usinage, la première partie (24) d'usinage et/ou la deuxième partie (26) d'usinage ayant des surfaces (32, 34) de meulage incurvées ou rectilignes.

10. Procédé suivant la revendication 9,
**caractérisé en ce que**
la première partie (24) d'usinage a une surface (32) principale de meulage incurvée et la deuxième partie (26) d'usinage a une surface (34) secondaire de meulage incurvée, le rayon de la surface (32) principale de meulage étant plus grand que le rayon de la surface (34) secondaire de meulage, de préférence le rayon de la surface (32) principale de meulage étant au moins deux fois plus grand que le rayon de la surface (34) secondaire de meulage
ou
la première partie (24) d'usinage a une surface (32) principale de meulage rectiligne et la deuxième partie (26) d'usinage a une surface (34) secondaire de meulage rectiligne, dans lequel au moyen de la surface (32) principale de meulage, on élimine plus de matière du substrat (2) donneur qu'avec la surface (34) secondaire de meulage
ou
la première partie (24) d'usinage a une surface (32) principale de meulage rectiligne et la deuxième partie (26) d'usinage a une surface (34) secondaire de meulage incurvée
ou
la première partie (24) d'usinage a une surface (32) principale de meulage incurvée et la deuxième partie (26) d'usinage a une surface (34) secondaire de meulage rectiligne.

11. Procédé suivant l'une des revendications précédentes,
**caractérisé en ce que**
on produit le rayonnement (8) laser d'ablation à une longueur d'onde dans le domaine compris entre 300 nm et 10 µm, à une durée d'impulsion de moins de 100 microsecondes et de préférence de moins de 1 microseconde et, d'une manière particulièrement préférée, de moins de 1/10 de microsecondes et à une énergie d'impulsion de plus de 1 µJ et de préférence de plus de 10 µJ.

12. Procédé suivant la revendication 4,
**caractérisé en ce que**
dans toute la région entre la région de détachement et la surface à distance de manière homogène de la région de détachement, de la matière à enlever décrit une forme annulaire, notamment une forme cylindrique.

13. Procédé suivant l'une des revendications précédentes 1 à 8,
**caractérisé en ce que**
on émet le rayonnement (12) laser d'un dispositif (46) laser, le dispositif (46) laser est un laser à picoseconde ou un laser à femtoseconde
et/ou
on choisit l'énergie du rayonnement (12) laser, notamment du laser fs, de manière à ce que la propagation d'endommagement de chaque modification (10) dans le substrat (2) donneur soit plus petite que 3 fois la longueur de Rayleigh, de préférence plus petite que la longueur de Rayleigh et d'une manière particulièrement préférée plus petite qu'un tiers de la longueur de Rayleigh
et/ou
on choisit la longueur d'onde du rayonnement (12) laser, notamment du laser fs, de manière à ce que l'absorption du substrat (2) donneur soit plus petite que 10cm⁻¹ et de manière préférée plus petite que 1 cm⁻¹ et d'une manière particulièrement préférée plus petite que 0,1 cm⁻¹
et/ou
les diverses modifications (10) proviennent d'une excitation de photons multiples provoquée par le rayonnement (12) laser, notamment du laser fs.

14. Procédé suivant la revendication 1 à 9,
**caractérisé en ce que**
le rayonnement (12) laser de production de modifications (10) pénètre par une surface (16) dans la tranche (2) de donneur, qui fait partie de la plaquette (1) à semi-conducteur à séparer.

15. Procédé suivant l'une des revendications précédentes,
**caractérisé en ce que**
la couche (14) de production de tension a un polymère, notamment du polydiméthylsiloxane (PDMS) ou en est constituée, la charge thermique s'effectuant de manière à ce que le polymère subisse une transition à l'état vitreux, la couche (14) de production de tension étant mise à température, notamment au moyen d'azote liquide à une température inférieure à la température ambiante ou inférieure à 0°C ou inférieure à -50°C ou inférieure à -100°C ou inférieure à -110°C, notamment à une température inférieure au point de transition à l'état vitreux de la couche (14) de production de tension.

16. Procédé suivant l'une des revendications précédentes,
**caractérisé en ce que**
le rayonnement d'ablation comprend des ions accélérés et/ou un plasma et/ou un rayonnement laser et/ou est formé par un chauffage par faisceau d'électrons ou par des ondes ultrasonores et/ou fait partie d'un procédé lithographique (faisceau d'électrons, UV, ions, plasma) ayant au moins un stade d'attaque après revêtement, effectué auparavant, par un vernis photosensible et/ou le fluide d'ablation est un jet de liquide, notamment un jet d'eau d'un processus de coupe par jet d'eau.
